(19) Europäisches Patentamt / European Patent Office / Office européen des brevets

(11) **EP 2 192 570 A1**

(12) **EUROPEAN PATENT APPLICATION**

(43) Date of publication:
**02.06.2010 Bulletin 2010/22**

(51) Int Cl.:
**G09G 3/32** *(2006.01)*

(21) Application number: **09176248.4**

(22) Date of filing: **17.11.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **26.11.2008 KR 20080118053**

(71) Applicant: **Samsung Mobile Display Co., Ltd.**
**Yongin-city, Gyunggi-do 446-711 (KR)**

(72) Inventor: **CHOI, Sang-Moo**
**Gyeonggi-Do (KR)**

(74) Representative: **Walaski, Jan Filip**
**Venner Shipley LLP**
**20 Little Britain**
**London**
**EC1A 7DH (GB)**

(54) **Pixel and organic light emitting display device using the same**

(57) A pixel (140) includes an organic light emitting diode (OLED); a first transistor (n1) for supplying current to the organic light emitting diode; a second transistor (n2) coupled between a gate electrode (N1) of the first transistor and a data line (Dm), the second transistor (n2) for supplying a data signal from the data line (Dm) to the gate electrode (N1) of the first transistor when a scan signal (Sn) is supplied through a scan line coupled to the pixel; a storage capacitor (Cst) having a first terminal coupled to the gate electrode (N1) of the first transistor; a fourth transistor (n4) coupled to a second terminal (N2) of the storage capacitor (Cst), the fourth transistor (n4) for supplying a reference voltage (Vref) to the second terminal (N2) of the storage capacitor (Cst) when the scan signal (Sn) is supplied through the Sean line; and a third transistor (n3) coupled between the second terminal (N2) of the storage capacitor (Cst) and an anode electrode (N3) of the organic light emitting diode.

FIG. 3

**Description**

The present invention relates to a pixel and an organic light emitting display device using the same, and more particularly, to a pixel capable of generating a desired luminance, and an organic light emitting display device using the pixel.

Recently, various types of flat panel display devices have been developed having reduced weight and volume in comparison to cathode ray tubes. Flat panel display devices include liquid crystal display devices, field emission display devices, plasma display panels, and organic light emitting display devices, among others.

Among these flat panel display devices, the organic light emitting display device displays images using organic light emitting diodes that emit light through the recombination of electrons and holes. The organic light emitting display device has a fast response time and is driven with low power consumption.

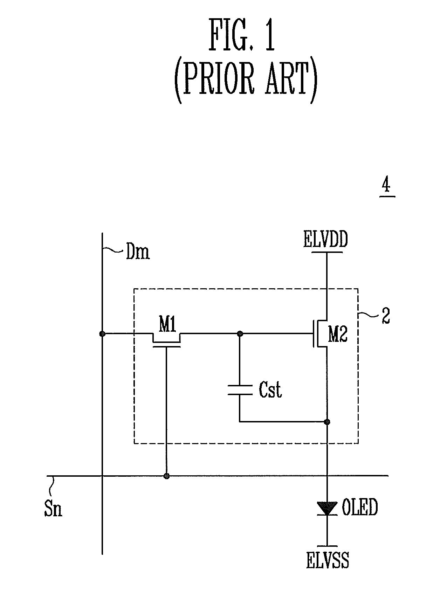

FIG. 1 is a circuit diagram of a conventional pixel of an organic light emitting display device. In FIG. 1, transistors included in the pixel are NMOS transistors.

Referring to FIG. 1, the conventional pixel 4 of the organic light emitting display device includes an organic light emitting diode OLED and a pixel circuit 2 connected to a data line Dm and a scan line Sn to control the organic light emitting diode OLED.

An anode electrode of the organic light emitting diode OLED is coupled to the pixel circuit 2, and a cathode electrode of the organic light emitting diode OLED is coupled to a second power source ELVSS. The organic light emitting diode OLED emits light having luminance corresponding to current supplied from the pixel circuit 2.

When a scan signal is supplied to the pixel circuit 2 through the scan line Sn, the pixel circuit 2 controls an amount of current supplied to the organic light emitting diode OLED in response to a data signal supplied through the data line Dm. To this end, the pixel circuit 2 includes a second transistor M2 (i.e., a driving transistor) coupled between a first power source ELVDD and the organic light emitting diode OLED; a first transistor M1 coupled between the second transistor M2 and the data line Dm, with a gate electrode coupled to the scan line Sn; and a storage capacitor Cst coupled between a gate electrode and a second electrode of the second transistor M2.

A gate electrode of the first transistor M1 is coupled to the scan line Sn, and a first electrode of the first transistor M1 is coupled to the data line Dm. A second electrode of the first transistor M1 is coupled to one terminal of the storage capacitor Cst. Here, the first electrode is either a source or drain electrode, and the second electrode is the other electrode different from the first electrode. For example, if the first electrode is a drain electrode, the second electrode is a source electrode. When a scan signal is supplied to the first transistor M1 from the scan line Sn, the first transistor M1 is turned on, and a data signal supplied from the data line Dm is supplied to the storage capacitor Cst. At this time, a voltage corresponding to the data signal is charged into the storage capacitor Cst.

The gate electrode of the second transistor M2 is coupled to the one terminal of the storage capacitor Cst, and a first electrode of the second transistor M2 is coupled to the first power source ELVDD. The second electrode of the second transistor M2 is coupled to the other terminal of the storage capacitor Cst and the anode electrode of the organic light emitting diode OLED. The second transistor M2 controls an amount of current flowing from the first power source ELVDD through the organic light emitting diode OLED to the second power source ELVSS, the amount of current corresponding to the voltage stored in the storage capacitor Cst.

One terminal of the storage capacitor Cst is coupled to the gate electrode of the second transistor M2, and the other terminal of the storage capacitor Cst is coupled to the anode electrode of the organic light emitting diode OLED. A voltage corresponding to a data signal is charged into the storage capacitor Cst.

The conventional pixel 4 displays an image having a predetermined luminance by supplying current corresponding to the voltage charged into the storage capacitor Cst to the organic light emitting diode OLED.

However, over time, the conventional pixel 4 does not display an image having a desired luminance, due to a degradation of the organic light emitting diode OLED and a voltage drop of the second power source ELVSS. More specifically, current flowing through the organic light emitting diode OLED is determined based on

Equation 1:

$$I_{oled} = \beta \{Vdata - (ELVSS + V_{oled}) - Vth(M2)\}^2 \qquad (1)$$

In Equation 1, β denotes a constant, Vdata denotes a voltage of a data signal, and Voled denotes a voltage applied to an organic light emitting diode.

Referring to Equation 1, the current Ioled flowing through the organic light emitting diode OLED is influenced by the second power source ELVSS and the voltage Voled applied to the organic light emitting diode OLED. Here, the voltage applied from the second power source ELVSS may vary depending on a position of the pixel 4 in the organic light emitting display device, due to the voltage drop of the second power source ELVSS. The voltage Voled applied to the organic light emitting diode OLED is changed corresponding to the degradation of the organic light emitting diode OLED. Therefore, the conventional pixel does not display an image having a desired luminance due to the voltage drop of the second power source ELVSS and the degradation of the organic light emitting diode OLED.

Accordingly, exemplary embodiments of the present invention provide a pixel capable of generating a desired luminance, and an organic light emitting display device using the pixel.

An aspect of an exemplary embodiment of the present invention provides a pixel including an organic light emitting diode; a first transistor for supplying current to the organic light emitting diode; a second transistor coupled between a gate electrode of the first transistor and a data line, the second transistor for supplying a data signal from the data line to the gate electrode of the first transistor when a scan signal is supplied to a scan line coupled to the pixel; a storage capacitor having a first terminal coupled to the gate electrode of the first transistor; a fourth transistor coupled to a second terminal of the storage capacitor, the fourth transistor for supplying a reference voltage to the second terminal of the storage capacitor when the scan signal is supplied to the scan line; and a third transistor coupled between the second terminal of the storage capacitor and an anode electrode of the organic light emitting diode, wherein the third transistor and the fourth transistor are on at different times.

The fourth transistor may be coupled between the second terminal of the storage capacitor and a reference power source for supplying the reference voltage. The reference voltage may be a voltage at which the fourth transistor turns on when the scan signal is supplied to the scan line and turns off when the scan signal is not supplied to the scan line. A gate electrode of the third transistor may be coupled to a light emission control line for supplying a light emission control signal for turning the third transistor off when the scan signal is supplied.

An aspect of another exemplary embodiment of the present invention provides an organic light emitting display device, including a scan driver for sequentially supplying scan signals to scan lines; a data driver for supplying data signals to data lines in synchronization with the scan signals; and pixels positioned at crossing regions of the scan lines and the data lines, wherein each of the pixels includes an organic light emitting diode; a first transistor for supplying current to the organic light emitting diode; a second transistor coupled between a gate electrode of the first transistor and a corresponding data line of the data lines, the second transistor for supplying data signals from the corresponding data line to the gaet electrode of the first transistor when the scan signal is supplied to a corresponding scan line of the scan lines; a storage capacitor having a first terminal coupled to the gate electrode of the first transistor; a fourth transistor coupled to a second terminal of the storage capacitor, the fourth transistor for supplying a reference voltage to the second terminal of the storage capacitor by being turned on when the scan signal is supplied to the corresponding scan line; and a third transistor coupled between the second terminal of the storage capacitor and an anode electrode of the organic light emitting diode, wherein the third transistor and the fourth transistor are on at different times.

The scan driver may be further configured to sequentially supply light emission control signals to light emission control lines parallel to the scan lines and coupled to the pixels. A light emission control signal of the light emission control signals supplied to an i-th ("i" is a natural number) light emission control line of the light emission control lines may be for turning the third transistor off when a scan signal is supplied to an i-th scan line of the scan lines.

In a pixel and an organic light emitting display device according to exemplary embodiments of the present invention, an.amount of current flowing through an organic light emitting diode can be controlled regardless of variations in voltage from a second power source ELVSS and degradation of the organic light emitting diode. Accordingly, in exemplary embodiments of the present invention, an image having a desired luminance may be displayed.

The accompanying drawings illustrate exemplary embodiments of the present invention, and, together with the description, serve to explain the principles of the present invention.

FIG. 1 is a circuit diagram of a conventional pixel.
FIG. 2 is a schematic block diagram of an organic light emitting display device according to an embodiment of the present invention.
FIG. 3 is a circuit diagram of a pixel according to a first embodiment of the present invention.
FIG. 4 is a waveform diagram illustrating a method of driving the pixel shown in FIG. 3.
FIG. 5 is a circuit diagram of a pixel according to a second embodiment of the present invention.
FIG. 6 is a circuit diagram of a pixel according to a third embodiment of the present invention.
FIG. 7 is a graph illustrating changes in current flowing through an organic light emitting diode depending on changes in voltage of a second power source.

Hereinafter, certain exemplary embodiments according to the present invention will be described with reference to the accompanying drawings. Here, when a first element is described as being coupled to a second element, the first element may be directly coupled to the second element, or may be indirectly coupled to the second element via one or more additional elements. Further, some of the elements that are not essential to the complete understanding of the invention are omitted for clarity. Also, like reference numerals refer to like elements throughout.

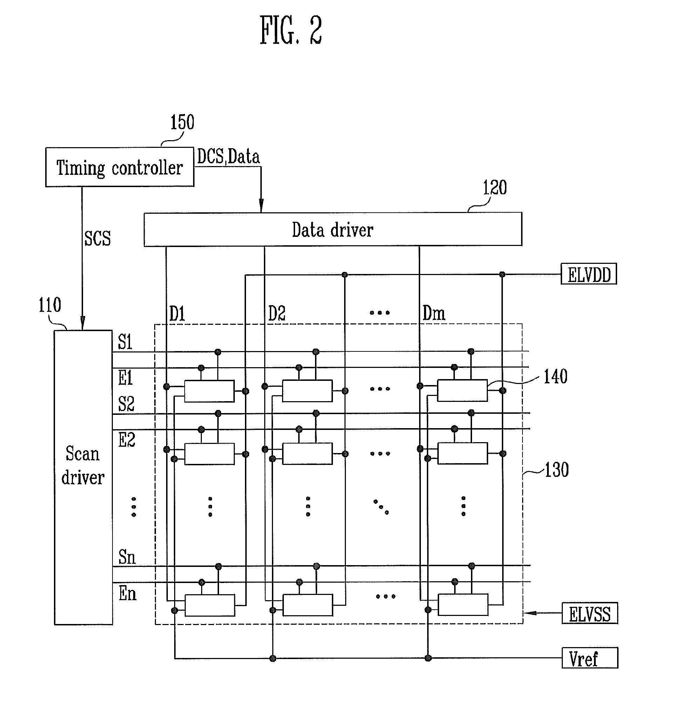

FIG. 2 is a schematic block diagram of an organic light emitting display device according to an embodiment of the present invention.

Referring to FIG. 2, the organic light emitting display device according to the embodiment of the present invention includes pixels 140 positioned to be respectively coupled to scan lines S1 to Sn, light emission control lines E1 to En and data lines D1 to Dm; a scan driver 110 for driving the scan lines S1 to Sn and the light emission control lines E1 to En; a data driver 120 for driving the data lines D1 to Dm; and a timing controller 150 for controlling the scan driver 110 and the data driver 120.

The scan driver 110 receives a scan driving control signal SCS from the timing controller 150. The scan driver 110 generates a scan signal and sequentially supplies the generated scan signal to the scan lines S1 to Sn. The scan driver 110 also generates a light emission control signal and sequentially supplies the light emission control signal to the light emission control lines E1 to En. The scan signal is set as a voltage (e.g., a high level voltage) at which transistors are turned on, and the light emission control signal is set as a voltage (e.g., a low level voltage) at which the transistors are turned off. The light emission control signal is generally set to have a longer duration than the scan signal, and a light emission control signal supplied through an i-th ("i" is a natural number) light emission control line Ei is supplied to overlap with a scan signal supplied through an i-th scan line Si.

The data driver 120 receives a data driving control signal DCS supplied from the timing controller 150. The data driver 120 supplies data signals to the data lines D1 to Dm in synchronization with the scan signals.

The timing controller 150 generates a data driving control signal DCS and a scan driving control signal SCS in response to synchronization signals supplied from the outside. The data driving control signal DCS generated from the timing controller 150 is supplied to the data driver 120, and the scan driving control signal SCS generated from the timing controller 150 is supplied to the scan driver 110. The timing controller 150 also supplies data Data supplied from the outside to the data driver 120.

A display unit 130 receives a first power source ELVDD, a second power source ELVSS and a reference power source Vref, and supplies them to each of the pixels 140. Each of the pixels 140 receiving the first power source ELVDD, the second power source ELVSS and the reference power source Vref generates light in response to the data signals. To this end, each of the pixels 140 includes a plurality of transistors, which may be NMOS transistors. In other embodiments, some or all of the plurality of transistors may be PMOS transistors.

Here, the voltage of the first power source ELVDD is set higher than that of the second power source ELVSS so that current is supplied to the organic light emitting diodes. A voltage of the reference power source Vref is set as a DC voltage source having a constant voltage. Here, the reference power source Vref may be supplied to first electrodes of some of the transistors. The voltage of the reference power source Vref is set as a voltage at which the transistors may be turned on when a scan signal is supplied to gate electrodes of the transistors and turned off when a scan signal is not supplied to the gate electrodes of the transistors. The voltage of the reference power source Vref is different from the voltage of the data signal.

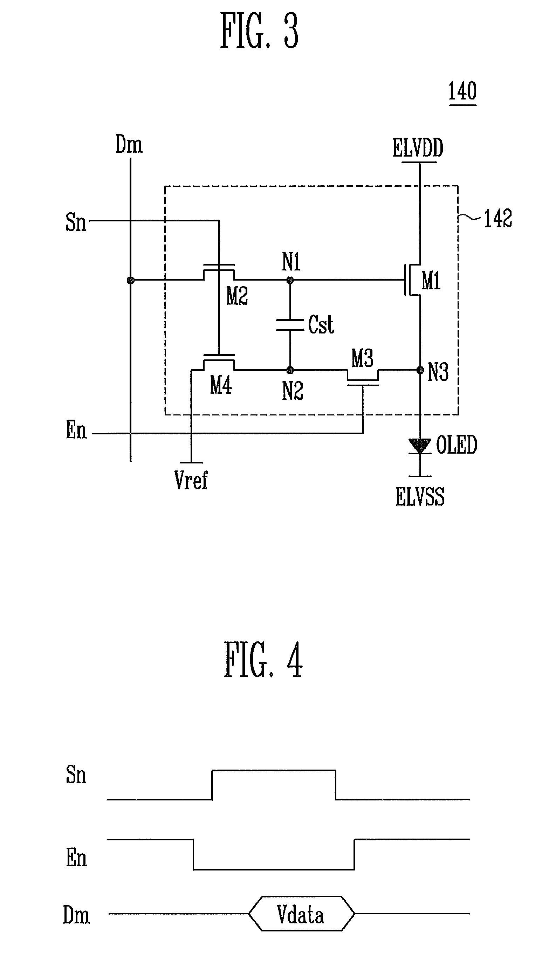

FIG. 3 is a circuit diagram of a pixel according to a first embodiment of the present invention. For convenience of illustration, a pixel 140 coupled to an n-th scan line Sn and an m-th data line Dm is shown in FIG. 3.

Referring to FIG. 3, the pixel 140 according to the first embodiment of the present invention includes an organic light emitting diode OLED and a pixel circuit 142 coupled to a data line Dm, a scan line Sn and a light emission control line En to control an amount of current flowing through the organic light emitting diode OLED.

An anode electrode of the organic light emitting diode OLED is coupled to the pixel circuit 142, and a cathode electrode of the organic light emitting diode OLED is coupled to a second power source ELVSS. The organic light emitting diode OLED generates light having a luminance (e.g., a predetermined luminance) corresponding to current supplied from the pixel circuit 142.

When a scan signal is supplied to the pixel circuit 142 through the scan line Sn, the pixel circuit 142 receives a data signal supplied from the data line Dm and supplies current corresponding to the data signal to the organic light emitting diode OLED. To this end, the pixel circuit 142 includes first to fourth transistors M1 to M4 and a storage capacitor Cst.

A gate electrode of the first transistor M1 is coupled to a first node N1, and a first electrode of the first transistor M1 is coupled to a first power source ELVDD. A second electrode of the first transistor M1 is coupled to the anode electrode of the organic light emitting diode OLED at a third node N3. The first transistor M1 controls an amount of current that flows from the first power source ELVDD to the second power source ELVSS via the organic light emitting diode OLED, corresponding to a voltage applied to the first node N1.

A gate electrode of the second transistor M2 is coupled to the scan line Sn, and a first electrode of the second transistor M2 is coupled to the data line Dm. A second electrode of the second transistor M2 is coupled to the first node N1. When a scan signal is supplied to the second transistor M2 through the scan line Sn, the second transistor M2 is turned on to allow the first node N1 to be electrically connected to the data line Dm.

A gate electrode of the third transistor M3 is coupled to the light emission control line En, and a first electrode of the third transistor M3 is coupled to a second node N2. A second electrode of the third transistor M3 is coupled to the anode electrode of the organic light emitting diode OLED. When a light emission control signal is supplied to the third transistor M3 through the light emission control line En, the third transistor M3 is turned off. Otherwise, the third transistor M3 is turned on.

A gate electrode of the fourth transistor M4 is coupled to the scan line Sn, and a first electrode of the fourth transistor M4 is coupled to the reference power source Vref. A second electrode of the fourth transistor M4 is coupled to the second node N2. When a scan signal is supplied to the fourth transistor M4 through the scan line Sn, the fourth transistor M4 is turned on and supplies the voltage of the reference voltage Vref to the second node N2. The third and fourth transistors M3 and M4 are generally not turned on at the same time.

The storage capacitor Cst is coupled between the first node N1 and the second node N2 (i.e., a common node between the third and fourth transistors M3 and M4). A voltage (e.g., a predetermined voltage) is charged into the storage capacitor in response to a data signal.

FIG. 4 is a waveform diagram illustrating a method of driving the pixel shown in FIG. 3. In FIG. 4, Vdata refers to a voltage of a data signal. The transistors included in the pixel shown in FIG. 3 are NMOS transistors.

An operation of the pixel will be described in detail in conjunction with FIGS. 3 and 4. First, a light emission control signal (e.g., a low light emission control signal) is supplied through the light emission control line En, and the third transistor M3 is turned off.

Thereafter, a scan signal (e.g., a high scan signal) is supplied through the scan line Sn, and the second and fourth transistors M2 and M4 are turned on. When the second transistor M2 is turned on, a data signal is supplied to the first node N1. When the fourth transistor M4 is turned on, the reference power source Vref is supplied to the second node N2.

When the data signal is supplied to the first node N1, a predetermined current is supplied from the first transistor M1 to the organic light emitting diode OLED. At this time, the voltage applied to the third node N3 is set based on Equation 2:

$$V_{N3} = ELVSS + Voled \qquad (2)$$

In Equation 2, Voled denotes a voltage applied to the organic light emitting diode OLED corresponding to the current supplied from the first transistor M1.

After the data signal is supplied to the first node N1, the supply of the scan signal through the scan line Sn is stopped. When the supply of the scan signal through the scan line Sn is stopped (e.g., the scan signal becomes low), the second and fourth transistors M2 and M4 are turned off.

Thereafter, the supply of the light emission control signal through the light emission control line En is stopped (e.g., the light emission control signal becomes high), and the third transistor M3 is turned on. When the third transistor M3 is turned on, the second and third node N2 and N3 are electrically coupled to each other. Therefore, the voltage at the third node N3 changes depending on a voltage variation determined based on Equation 3:

$$\Delta V_{N3} = Vref - (ELVSS + Voled) \qquad (3)$$

In Equation 3, $\Delta V_{N3}$ denotes a voltage variation at the third node N3.

When the voltage at the third node N3 is changed based on Equation 3, a voltage at the first node N1 is set based on Equation 4 due to coupling of the storage capacitor:

$$V_{N1} = Vdata - \Delta V_{N3} = Vdata - Vref + ELVSS + Voled \qquad (4)$$

When a voltage at the first node N1 is set based on Equation 4, the voltage between the gate and source electrodes of the first transistor M1 is set based on Equation 5:

$$V_{gs}(M1) = Vdata - Vref + ELVSS + Voled - (ELVSS + Voled) = Vdata - Vref \qquad (5)$$

When the voltage between the gate and source electrodes of the first transistor M1 is set based on Equation 5, current Ioled flowing from the first transistor M1 to the organic light emitting diode OLED is set based on Equation 6:

$$I_{oled} = \beta(Vdata - Vref - Vth)^2 \qquad (6)$$

Referring to Equation 6, the current Ioled flowing to the organic light emitting diode OLED is not dependent upon the second power source ELVSS and the voltage Voled applied to the organic light emitting diode OLED. Accordingly, in the present invention, an image having a desired luminance can be displayed despite a voltage drop of the second power source ELVSS and degradation of the organic light emitting diode OLED.

Since a gray level is determined by the voltage Vdata of a data signal and the reference voltage Vref, the current Ioled is set regardless of the voltage Voled applied to the organic light emitting diode OLED. Accordingly, in the pixel of the present invention, the data voltage difference between high and low gray levels can be reduced compared to a conventional pixel.

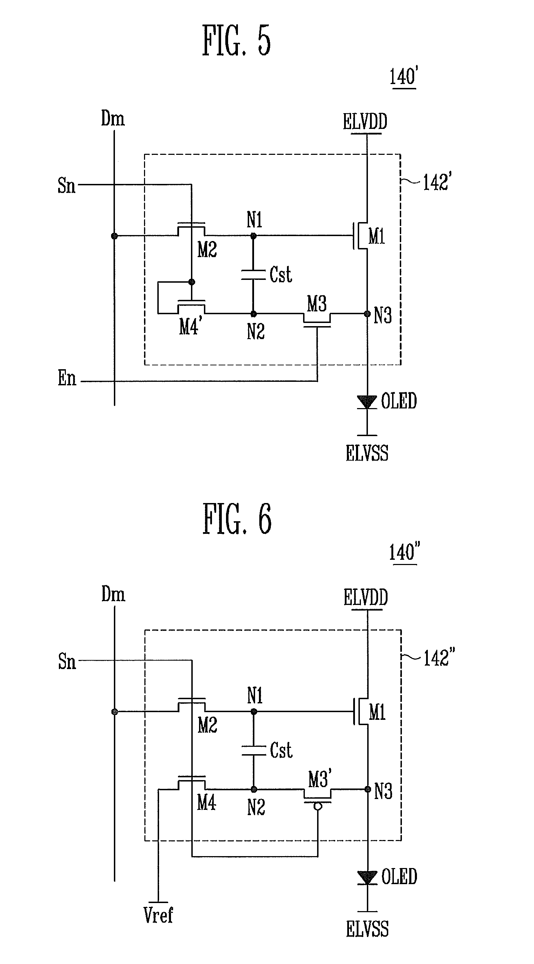

FIG. 5 is a circuit diagram of a pixel according to a second embodiment of the present invention. In FIG. 5, elements identical to those of FIG. 3 are provided with the same reference numerals, and their detailed descriptions will be omitted.

Referring to FIG. 5, the pixel 140' according to the second embodiment of the present invention includes an organic light emitting diode OLED and a pixel circuit 142' coupled to a data line Dm, a scan line Sn and a light emission control line En to control an amount of current flowing through the organic light emitting diode OLED.

A first electrode and a gate electrode of a fourth transistor M4' included in the pixel circuit 142' are coupled to the scan line Sn, and a second electrode of the fourth transistor M4' is coupled to a second node N2. That is, the fourth transistor M4' is diode-coupled so that current can flow from the scan line Sn to the second node N2. When a scan signal is supplied through the scan line Sn, the fourth transistor M4' supplies the voltage of the scan signal (more specifically, the voltage obtained by subtracting the threshold voltage of the fourth transistor M4' from the scan signal) to the second node N2. That is, in the pixel 140' according to the second embodiment of the present invention, the voltage of the scan signal is used as a reference power source Vref. The other operations of the pixel 140' are identical to those of the pixel shown in FIG. 3.

FIG. 6 is a circuit diagram of a pixel according to a third embodiment of the present invention. In FIG. 6, elements identical to those of FIG. 3 are provided with the same reference numerals, and their detailed descriptions will be omitted.

Referring to FIG. 6, the pixel 140" according to the third embodiment of the present invention includes an organic light emitting diode OLED and a pixel circuit 142" coupled to a data line Dm and a scan line Sn to control an amount of current flowing through the organic light emitting diode OLED.

A third transistor M3' included in the pixel circuit 142" is a PMOS transistor and coupled to the scan line Sn. The third transistor M3' controls the voltage at a second node N2 by being turned on when a fourth transistor M4 is turned off, and vice versa. That is, the third transistor M3' is a PMOS transistor and turned off during a period at which a high scan signal is supplied through the scan line Sn. The third transistor M3' is turned on during other times. Operations of the pixel 140" except the third transistor M3' are identical to those of the pixel shown in FIG. 3.

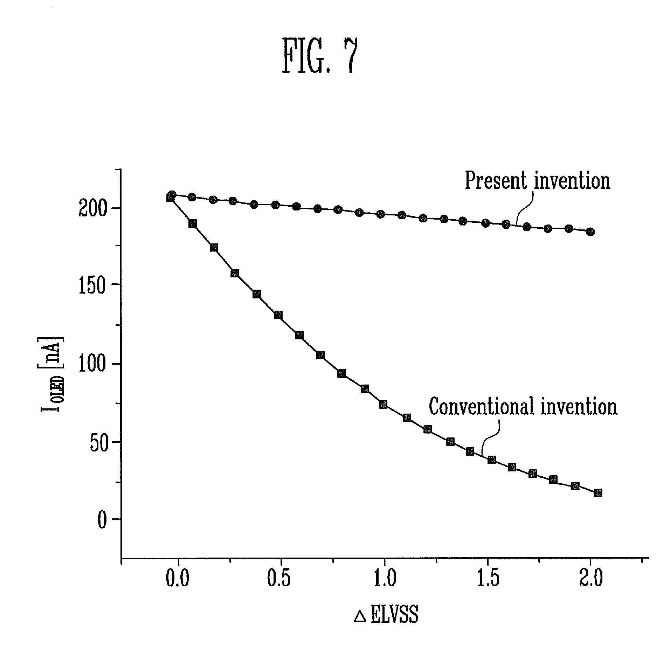

FIG. 7 is a graph illustrating simulation results of the pixel shown in FIG. 3.

Referring to FIG. 7, in the pixel 140, 140', 140" according to an exemplary embodiment of the present invention, the current Ioled supplied to the organic light emitting diode OLED remains relatively constant despite changes in voltage of the second power source ELVSS.

Referring to Equation 6, the current Ioled flowing through the organic light emitting diode OLED in the pixel of the present invention remains constant despite changes in voltage of the second power source ELVSS. However, in the simulation result, the current Ioled supplied to the organic light emitting diode OLED exhibits a slight change due to the change in voltage of the second power source ELVSS. The current Ioled is slightly altered due to a parasitic capacitance of the first transistor, but this is a relatively small amount of current change which may be negligible.

While the present invention has been described in connection with certain exemplary embodiments, it is to be understood that the invention is not limited to the disclosed embodiments, but instead is intended to cover various modifications and equivalent arrangements included within the scope of the appended claims.

**Claims**

1. A pixel (140, 140', 140") composing:

an organic light emitting diode;
a first transistor (M1) for supplying current to the organic light emitting diode;
a second transistor (M2) coupled between a gate electrode of the first transistor and a data line (Dm) for supplying a data signal from the data line to the gate electrode of the first transistor when a scan signal is supplied to a scan line coupled to the pixel;
a storage capacitor (Cst) having a first terminal coupled to the gate electrode of the first transistor;
a third transistor (M3, M3') coupled between the second terminal of the storage capacitor (Cst) and a first electrode of the organic light emitting diode;
a fourth transistor (M4, M4') coupled to a second terminal of the storage capacitor for supplying a reference voltage to the second terminal of the storage capacitor when the scan signal is supplied to the scan line;

wherein the third transistor and the fourth transistor are on at different times.

2. The pixel of claim 1, wherein the gate electrodes of the second and the fourth transistors (M2, M4, M4') are coupled to the scan line.

3. The pixel of claim 1 or 2, wherein the fourth transistor (M4) is coupled between the second terminal of the storage capacitor and a reference power source for supplying the reference voltage.

4. The pixel of claim 1, 2 or 3, wherein the reference voltage is a voltage at which the fourth transistor turns on when the scan signal is supplied to the scan line and turns off when the scan signal is not supplied to the scan line.

5. The pixel of claim 1 or 2, wherein a gate electrode of the third transistor is coupled to a light emission control line for supplying a light emission control signal for turning the third transistor off when the scan signal is supplied.

6. The pixel of claim 1 or 2, wherein a first electrode and a gate electrode of the fourth transistor (M4') are coupled to the scan line, and a second electrode of the fourth transistor is coupled to the second terminal of the storage capacitor.

7. The pixel of claim 6, wherein the reference voltage is a difference between a voltage of the scan signal and a threshold voltage of the fourth transistor.

8. The pixel of any one of the preceding claims, wherein the first transistor and the fourth transistor are NMOS transistors.

9. The pixel of any one of the preceding claims, wherein a gate electrode of the third transistor (M3) is coupled to a light emission control line for supplying a light emission control signal for turning the third transistor off when the scan signal is applied.

10. The pixel of any one of claims 1 to 8, wherein the first transistor, the second transistor and the fourth transistor (M1, M2, M4) are NMOS transistors, and the third transistor (M3') is a PMOS transistor.

11. The pixel of claim 10, wherein a gate electrode of the third transistor (M3') is coupled to the scan line.

12. An organic light emitting display device comprising:

a scan driver for sequentially supplying scan signals to scan lines;
a data driver for supplying data signals to data lines in synchronization with the scan signals; and
pixels positioned at crossing regions of the scan lines and the data lines,

wherein each of the pixels comprises a pixel according to any one of the preceding claims.

13. The organic light emitting display device of claim 12, wherein the scan driver is further configured to sequentially supply light emission control signals to light emission control lines parallel to the scan lines and coupled to the pixels.

# FIG. 1
# (PRIOR ART)

# FIG. 2

# FIG. 3

140

# FIG. 4

# FIG. 5

140'

# FIG. 6

140"

# FIG. 7

Europäisches
Patentamt

European
Patent Office

Office européen
des brevets

# EUROPEAN SEARCH REPORT

Application Number

EP 09 17 6248

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2006/007070 A1 (SHIH LI-WEI [TW]) 12 January 2006 (2006-01-12) * paragraphs [0002], [0004] - [0006], [0010], [0023], [0025], [0026]; figures 2A,2B,3A * | 1-13 | INV. G09G3/32 |
| Y | EP 1 628 283 A1 (SONY CORP [JP]) 22 February 2006 (2006-02-22) * paragraphs [0264] - [0308]; figures 30-32 * | 1,3-13 | |
| Y | US 2006/066251 A1 (SIM JAE H [KR] SIM JAE HO [KR]) 30 March 2006 (2006-03-30) * paragraphs [0010], [0038] - [0055]; figures 2-6 * | 1-9,12, 13 | |
| Y | US 2005/243076 A1 (KIM BYEONG K [KR] ET AL KIM BYEONG KOO [KR] ET AL) 3 November 2005 (2005-11-03) * paragraphs [0049] - [0078]; figures 4-6 * | 1-13 | |
| Y | EP 1 635 324 A1 (SAMSUNG SDI CO LTD [KR]) 15 March 2006 (2006-03-15) * paragraphs [0037] - [0056]; figures 2,4A,5,6 * | 6,7 | TECHNICAL FIELDS SEARCHED (IPC)  G09G |

The present search report has been drawn up for all claims

| Place of search | Date of completion of the search | Examiner |
|---|---|---|
| Munich | 31 March 2010 | Ley, Théodore |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 09 17 6248

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2010

| Patent document cited in search report | | Publication date | Patent family member(s) | | Publication date |
|---|---|---|---|---|---|
| US 2006007070 | A1 | 12-01-2006 | CN | 1598915 A | 23-03-2005 |
| | | | JP | 2005346073 A | 15-12-2005 |
| | | | TW | 250486 B | 01-03-2006 |
| EP 1628283 | A1 | 22-02-2006 | CN | 1795484 A | 28-06-2006 |
| | | | JP | 4360121 B2 | 11-11-2009 |
| | | | JP | 2004347993 A | 09-12-2004 |
| | | | WO | 2004104975 A1 | 02-12-2004 |
| | | | KR | 20060023534 A | 14-03-2006 |
| | | | TW | 255438 B | 21-05-2006 |
| | | | US | 2007057873 A1 | 15-03-2007 |
| US 2006066251 | A1 | 30-03-2006 | KR | 20060028333 A | 29-03-2006 |
| US 2005243076 | A1 | 03-11-2005 | CN | 1694135 A | 09-11-2005 |
| | | | KR | 20050104971 A | 03-11-2005 |
| EP 1635324 | A1 | 15-03-2006 | CN | 1741110 A | 01-03-2006 |
| | | | JP | 2006065286 A | 09-03-2006 |
| | | | KR | 20060018763 A | 02-03-2006 |
| | | | US | 2006044236 A1 | 02-03-2006 |

EPO FORM P0459

For more details about this annex : see Official Journal of the European Patent Office, No. 12/82